# FASCICULE DE BREVET EUROPEEN

(11) **EP 2 396 884 B1**
(45) Date de publication et mention de la délivrance du brevet: **22.06.2016**
(21) Numéro de dépôt: 10708341.2
(22) Date de dépôt: 12.02.2010
(51) Int. Cl.: H03H 1/00, H03H 7/01, H03H 7/075

(54) **RESEAU DE FILTRAGE EN TECHNOLOGIE SILICIUM SI-HR**
FILTERUNGSNETZ IN DER HR-SI-SILIZIUMTECHNOLOGIE
FILTERING NETWORK IN HR-SI SILICON TECHNOLOGY

(30) Priorité: 12.02.2009 FR 0950904
(43) Date de publication de la demande: 21.12.2011
(73) Titulaire: Thomson Licensing, 92130 Issy-les-Moulineaux (FR)
(72) Inventeur: LO HINE TONG, Dominique, F-92443 Issy-les-Moulineaux Cedex (FR); LABABIDI, Raafat, F-92443 Issy-les-Moulineaux Cedex (FR); BARON, François, F-92443 Issy-les-Moulineaux Cedex (FR); LOUZIR, Ali, F-92443 Issy-les-Moulineaux Cedex (FR); JARRY, Bernard, F-92443 Issy-les-Moulineaux Cedex (FR); BARELAUD, Bruno, F-92443 Issy-les-Moulineaux Cedex (FR); LINTIGNAT, Julien, F-92443 Issy-les-Moulineaux Cedex (FR)
(74) Mandataire: Huchet, Anne
(86) Numéro de dépôt international: PCT/FR2010/050244
(87) Numéro de publication internationale: WO 2010/092308

(56) Documents cités:
- EP-A1- 0 998 036
- WO-A1-2008/013073
- FR-A1- 2 817 412
- US-A1- 2007 126 529
- US-A1- 2009 108 958
- LABABIDI M R; LO HINE TONG D; LOUZIR A; LINTIGNAT J; BARELAUD B; JARRY B: "High Resistive Silicon based low-pass active filter design for TV on mobile application" MICROWAVE SYMPOSIUM DIGEST, 2009. MTT '09. IEEE MTT-S INTERNATIONAL, IEEE, PISCATAWAY, NJ, USA, 7 juin 2009 (2009-06-07), pages 1053-1056, XP031490703 ISBN: 978-1-4244-2803-8

## Description

La présente invention concerne la réalisation d'un réseau de filtrage dans une technologie telle que la technologie Si-HR (Silicium à Haute Résistivité). Elle concerne notamment des terminaux multistandards s'appliquant par exemple, aux standards GSM et UMTS pour la téléphonie mobile et aux standards DVB-H/T pour la réception TV.

Un exemple d'un tel réseau de filtrage est un filtre passe-bas de base de type pseudo-elliptique, possédant 11 pôles et cinq zéros de transmission. Un tel réseau est apte à laisser passer le signal DVB-T situé dans la bande [462-862] MHz et à rejeter la bande d'émission GSM se trouvant dans la bande [890-915] MHz.

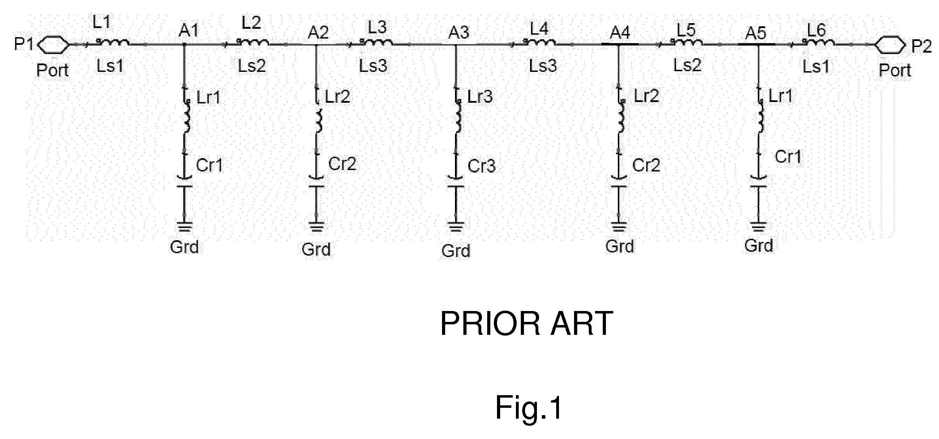

Un réseau de filtrage de ce type est décrit en figure 1. Le réseau est symétrique. En conséquence, les éléments de rang symétrique ont les mêmes valeurs. Le réseau comprend :
- des inductances de couplages L1 à L6 de valeurs Ls1, Ls2, Ls3, connectées en série entre un port d'entrée P1 et un port de sortie P2.
- des éléments résonants L/C série de valeur Lr1/Cr1, Lr2/Cr2, Lr3/Cr3 connectés en parallèle entre les points de connexion A1 à A5 des inductances de couplage L1 à L6 et la masse.

Entre le point A1 de connexion des inductances L1et L2 et la masse est donc connecté un premier élément résonnant Lr1/Cr1. Entre le point A2 et la masse est donc connecté un deuxième élément résonnant Lr2/Cr2, et entre le point A3 et la masse est donc connecté un troisième élément résonnant Lr3/Cr3. Symétriquement entre le point A4 et la masse est connecté un élément résonnant Lr2/Cr2, et entre le point A5 et la masse est donc connecté un élément résonnant Lr1/Cr1. Ces éléments « L/C série » créent des zéros de transmission au voisinage immédiat de la fréquence de coupure pour augmenter la sélectivité du filtre.

Or selon un mode de réalisation usuel, pour réaliser le filtre on utilise des composants L/C discrets qu'on reporte sur un substrat à bas coût, de type FR4, la face inférieure de ce substrat servant de plan de masse, et la mise à masse de ces composants étant faite aux moyens de trous métallisés.

Il est connu de l'homme de l'art que la mise à la masse d'éléments RF n'est jamais parfaite et que cette imperfection peut être modélisée au premier ordre par une inductance parasite. S'agissant de la mise à la masse par des trous métallisés, la valeur de cette inductance dépendra notamment du diamètre des trous, de leur profondeur. Ces inductances parasites de masse peuvent dégrader sensiblement les performances d'une fonction, auquel cas il est nécessaire d'en tenir compte et de les compenser en ré-optimisant le design. Ainsi, dans le cas du réseau de filtrage de la figure 1, la minimisation des inductances parasites de masse est obtenue en reliant directement les éléments résonants L/C série au plan de masse inférieur du circuit du travers de trous métallisés.

La technologie Si-HR qui est aujourd'hui largement utilisée pour l'intégration de fonctions passives telles que les self-inductances, les capacités et résistances permet de concevoir des fonctions complètes, telles que par exemple filtres, baluns, mélangeurs, transformateur d'impédance, avec des performances remarquables au niveau du coût. Elle permet en outre de faire de l'intégration de systèmes en technologie dite SIP (SIP pour System-In-Package), auquel cas la technologie Si-HR sert non seulement à intégrer des éléments RLC mais sert également de support et d'interface aux divers circuits intégrés constituant le système.

Ces performances sont rendues possibles grâce à l'utilisation d'un silicium à haute résistivité (Si-HR) typiquement de 1000Ω.cm. Une structure de ce type comprend une première couche de substrat Si-HR, d'épaisseur typique de 300µm et de permittivité de l'ordre de 11.7, métallisée sur l'une des faces, correspondant à la face inférieure. Au dessus de l'autre face correspondant à la face supérieure, deux couches de conducteurs métalliques sont superposées. Entre la première couche métallique et la seconde couche supérieure est située une couche d'isolant, par exemple à base de SiO2,. Cette structure permet de réaliser des capacités MIM (Métal-Isolant-Métal) et des inductances bobinées sur la seconde couche supérieure. Les deux couches sont reliées grâce à des traversées métallisées. Sur la face supérieure de la seconde couche métallique se trouve une couche de passivation, par exemple, une couche de polymère organique BCB (benzocyclobutène).

Cependant la technologie actuelle ne permet pas de réaliser des traversées métallisées entre la première couche métallique et la face inférieure du silicium HR constituant un plan de masse. Elle ne permet donc pas de relier les éléments LC directement, c'est-à-dire au plus court, à la masse.

Cette limitation pose des problèmes de conception dans le cas particulier de fonctions complexes, par exemple, un filtre d'ordre élevé comprenant de multiples éléments à mettre à la masse, car les éléments parasites sont tels qu'ils peuvent dégrader et dénaturer complètement la réponse idéale au filtre sans qu'il y ait moyen d'y remédier.

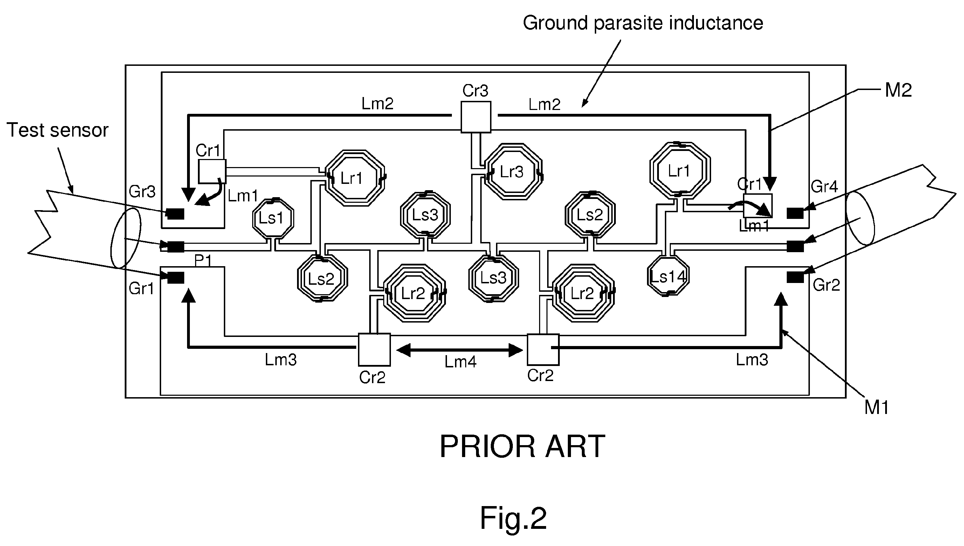

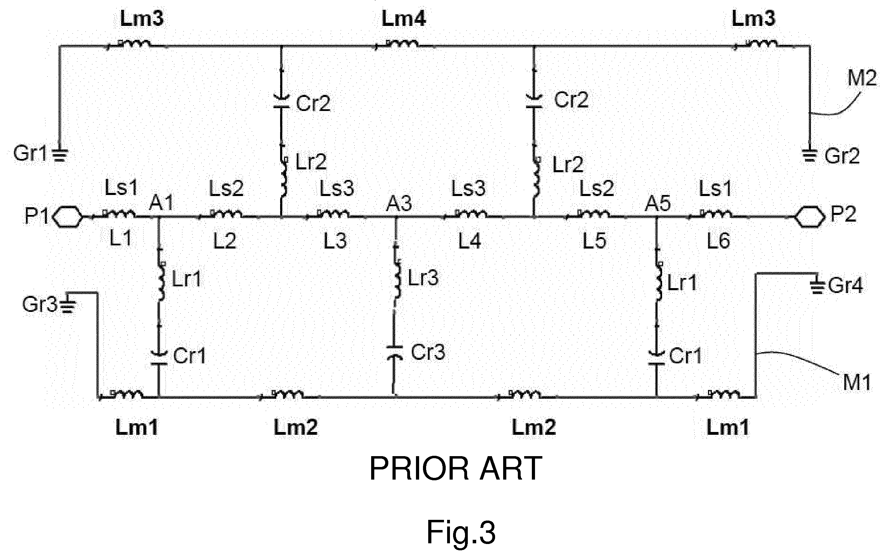

La figure 2 montre une vue en coupe d'une réalisation d'un filtre passif sur silicium à haute résistivité en technologie Si-HR, selon l'état de la technique tel que décrit ci-dessus et la figure 3 montre le schéma électrique d'un tel filtre passe-bas. Ce filtre classique comporte entre les ports entrée et sortie P1 et P2, des composants L/C série représentés par les capacités Cr1, Cr2, Cr3 et les inductances Lr1, Lr2, Lr3 et insérés en parallèle entre les inductances de couplage de valeurs Ls1, Ls2, Ls3, et des lignes de masse parasites M1,M2. Les lignes de masse parasites M1, M2 entre les points de masse Gr1, Gr2 et Gr3, Gr4 respectivement ont été modélisées par des inductances Lm1, Lm2, Lm3, Lm4.

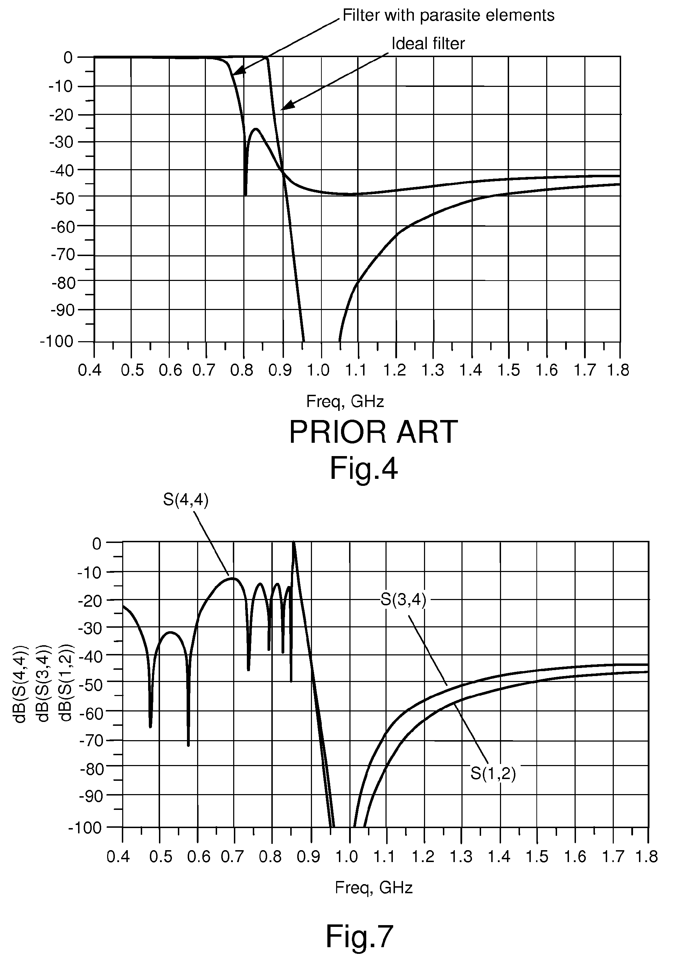

La réponse en transmission de ce filtre représentée sur la figure 4 montre donc non seulement un décalage de la fréquence de coupure mais aussi des zéros de transmission. L'atténuation au-delà de la fréquence de coupure est d'autre part beaucoup plus faible comparativement à celle du filtre idéal. L'ensemble de ces dégradations sont dues à la présence de ces inductances de masse parasites.

Dans le cas d'une mesure des pointes de test sont utilisées. Ces pointes sont posées sur le circuit comme représenté en Fig.2, l'âme centrale sur la ligne d'entrée ou de sortie, et les pointes de masse associées en bout des lignes de masse.

Les éléments résonants Lr1/Cr1, Lr2/Cr2 et en particulier Lr3/Cr3 ne peuvent donc plus être ramenés aux points de masse au plus court. Ces lignes de masse parasites Lm1, Lm2, Lm3, Lm4, de longueur non négligeable, comme représenté sur la figure 2 modifient donc fortement la réponse du filtre, et sont difficilement compensables.

La présente invention adresse donc la problématique de mise à la masse d'éléments constituants de cette fonction lorsque celle-ci est conçue en technologie Si-HR ou toute autre technologie qui ne permet pas de réaliser des traversées verticales de masse.

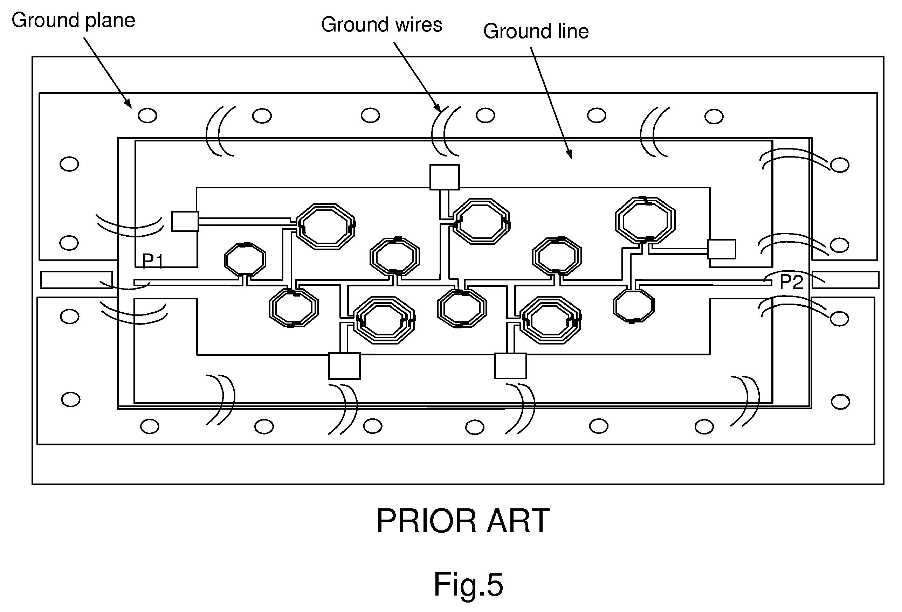

Différentes solutions connues de l'état de la technique sont proposées pour résoudre ce problème.
Une solution usuelle est de reporter ce circuit en technologie Si-HR sur le plan de masse d'un substrat de report, et de relier en plusieurs points les lignes de masse parasites à ce plan. Cette solution est illustrée par le circuit représenté par la figure 5 qui montre les nombreux fils, dits fils de masse, reliant les lignes de masse au plan de masse permettant de limiter les effets des inductances parasites de masse.

Le circuit en technologie Si-HR peut également être monté en mode dit flip-chip, ce circuit étant alors retourné sur le circuit de report et connecté à ce dernier à l'aide de billes. De nombreuses billes sont également nécessaires ici pour assurer une mise à la masse correcte du filtre.
US2007/126529 décrit un réseau de filtrage en technologie silicium. FR2817412 décrit un circuit de filtrage réalisé en circuit intégré. WO2008/013073 décrit un réseau de filtrage de bruit.
Une autre solution connue de l'état de la technique est de concevoir les filtres en mode différentiel. Cette solution consiste à_transformer un filtre référencé à la masse en un circuit en mode différentiel. Le filtre différentiel résulte dans ce cas d'une duplication du filtre non-différentiel suivant un axe de symétrie constitué par la ligne de masse globale. Un exemple est donné dans la thèse de M.L.GRIMA, « Conception d'un récepteur radiofréquence en technologie intégrée pour les systèmes de radioastronomie du futur », décembre 2007, Université d'Orléans.
Il est clair que cette solution présente un inconvénient majeur qui est le doublement des composants et de là celui de la surface de silicium. D'autre part elle nécessite l'utilisation de transformateurs pour convertir les signaux du mode différentiel en mode non différentiel.

L'invention propose une autre solution à ce problème décrite dans la revendication 1.

L'invention a l'avantage de fournir un réseau apte à annihiler les effets néfastes des lignes de masse et permet, en conséquence, de conserver une réponse de filtre idéal.
Un réseau de filtre selon l'invention ne possède que quatre points de masse, permettant en conséquence une inter-connexion aux autres fonctions simplifiée ainsi qu'une réduction du coût d'assemblage et d'intégration. L'emplacement des lignes de masse est réduit, libérant ainsi de la place sur le circuit Si-HR pour l'intégration d'autres fonctions.
L'invention rend possible le test direct des filtres sur « wafer », à l'aide de sonde, et la vérification des performances par rapport au gabarit final du filtre.
Le coût et la taille du circuit selon l'invention sont nettement réduits.

Les caractéristiques et avantages de l'invention mentionnés ci-dessus, ainsi que d'autres, apparaîtront plus clairement à la lecture de la description suivante, faite en relation avec les dessins joints, dans lesquels :
- La figure 1 déjà décrite, représente un filtre passe bas pseudo elliptique à 11 pôles ;
- la figure 2 représente une vue de dessus d'une technologie de réalisation de filtres sur silicium à haute résistivité Si-HR ; la figure 3 représente un réseau du filtre passe bas incluant les inductances parasites de masse ;
- la figure 4 représente la réponse en transmission d'un filtre avec des inductances parasites de masse comparée à celle d'un filtre idéal ;
- la figure 5 représente une vue de dessus d'une technologie de réalisation de filtres sur silicium à haute résistivité Si-HR incluant les fils de masse ;
- la figure 6 représente un réseau d'un filtre passe-bas selon l'invention ;
- la figure 7 représente la réponse en transmission dB (S(3,4)) et en réflexion dB (S(4,4)) du filtre de la figure 6 en comparaison de la réponse en transmission du filtre idéal ;
- la figure 8 représente une vue de dessus d'une réalisation de filtre selon l'invention sur silicium à haute résistivité Si-HR ;
- la figure 9 représente une vue de dessus d'une technologie de réalisation de filtres selon l'invention sur silicium à haute résistivité Si-HR incluant les fils de masse.

Pour simplifier la description, les mêmes références seront utilisées dans ces dernières figures pour désigner les éléments remplissant des fonctions identiques.

L'idée de l'invention est donc de compenser les effets néfastes des lignes de masse en introduisant des capacités qui vont entrer en résonance avec ces lignes, les rendant de ce fait transparentes d'un point de vue électrique.

Dans le même but, il est également proposé une autre manière de mettre à la masse les résonateurs d'un circuit silicium.
Le nouveau réseau de filtrage proposé ainsi que le circuit silicium associé sont décrits de manière détaillée ci-après. Les performances simulées sont de même indiquées comme preuve du concept.

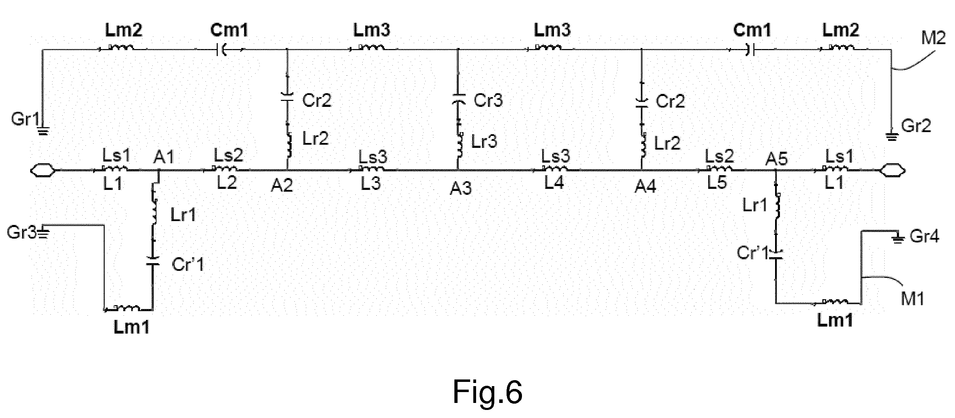

La figure 6 représente un réseau d'un filtre passe-bas d'ordre 11 selon l'invention.
Il s'agit du filtre passe bas précédemment décrit mais le principe de l'invention s'applique à tous autres filtres ou circuits passifs conçus sur circuit silicium.
Ce filtre est symétrique et les éléments de rang symétrique ont les mêmes valeurs. Il comporte, comme le filtre décrit avec la figure 1, des inductances de couplage L1 à L6 connectées en série entre un port d'entrée P1 et un port de sortie P2 ainsi que des éléments résonants « L/C série » appliqués entre les points de connexion A1 à A5 des inductances de couplage et les lignes de masse M1 et M2. On note, toutefois, que par rapport au réseau de la figure 3, l'élément résonant Lr3/Cr3 est relié maintenant à la même ligne de masse que les deux éléments résonants Lr2/Cr2. Cette disposition permet de réduire la valeur de l'inductance parasite de masse.
Une première ligne de masse M1 est connectée à deux points de masse Gr1, Gr2 qui sont reliés au plan de masse par l'intermédiaire de fils de masse. De même une deuxième ligne de masse M2 est connectée à deux points de masse Gr3, Gr4 qui sont reliés au plan de masse par l'intermédiaire de fils de masse. Les tronçons de lignes de masse forment des éléments inductifs parasites représentés par les inductances Lm1, Lm2, Lm3.
Selon l'invention, il a été introduit une capacité Cm1 en série avec chacune des inductances parasites Lm2 qui ramène à la masse l'ensemble des éléments du filtre La valeur de cette capacité est calculée de manière qu'elle résonne avec Lm2 à une fréquence située au plus proche de la bande GSM à rejeter., Par exemple, et à titre indicatif, avec les valeurs des éléments inductifs et capacitifs suivantes :
Inductances de couplage : Ls1=2.7 nH, Ls2=10nH, Ls3=9.1nH
Eléments L/C série: Lr1=12nH, Lr2=7.5nH, Lr3=7.5nH Cr'1=2.1pF, Cr2=3.4pF, Cr3=3.5pF et en supposant une inductance parasite Lm2 de 1 nH, Cm1 est fixée à 25pF de façon à avoir une résonance à 1.01 GHz. Ainsi à cette fréquence, qui est critique pour la sélectivité du filtre, l'impédance équivalente de Lm2 en série avec Cm1 est nulle, et les masses d'entrée/sortie sont ramenées en bout des résonateurs Lr2/Cr2. Les effets néfastes de ligne Lm2 sont donc annihilés.

Selon une variante de l'invention, il a été introduit une capacité en série avec chacune des inductances parasites Lm1 qui ramène à la masse ces éléments du filtre. La valeur de cette capacité est intégrée avec celle de la capacité Cr1 du premier résonateur, et la capacité du premier élément est remplacée par cet équivalent Cr'1. A titre d'exemple en supposant une inductance parasite Lm1 de 0.3nH, une valeur de Cr'1de 2.1pF est acceptable.
On peut noter que, avantageusement, le 3^{ème} résonateur Lr3/Cr3 est relié à la même ligne de masse M2 que les 2 résonateurs Lr2/Cr2. Cette disposition permet de compenser également la valeur de l'inductance parasite de masse Lm3 par la capacité Cm1. A titre d'exemple le réseau est équilibré pour avoir une résonance à 1.01 GHz avec une inductance parasite équivalente Lm3 de 0.5 nH.

L'invention consiste donc à introduire une capacité Cm1 connectée au point de masse correspondant et en série avec l'inductance parasite Lm2 qui ramène à la masse l'ensemble de ces éléments.

Une variante de l'invention consiste à ré-optimiser les valeurs de Lr3/Cr3, en tenant compte de la valeur des deux inductances Lm3, pour que le résonateur résonne à la fréquence initialement souhaitée.

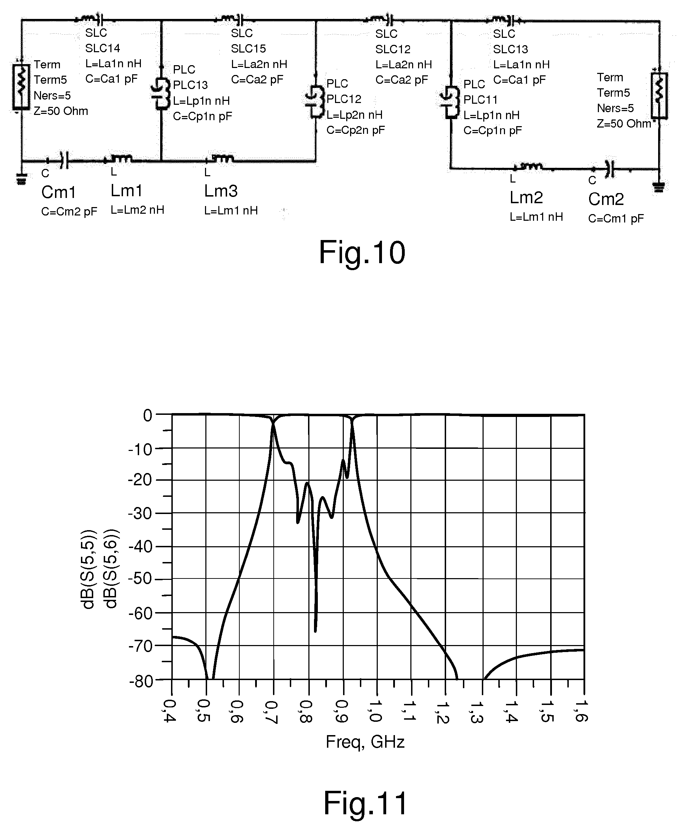

Comme représenté sur la figure 7, on voit que la réponse en transmission, comparée à celle de la solution idéale, montre que le nouveau réseau réussit bien à neutraliser les effets des lignes de masse parasites. La réponse en réflexion montre par ailleurs que le filtre reste bien adapté.

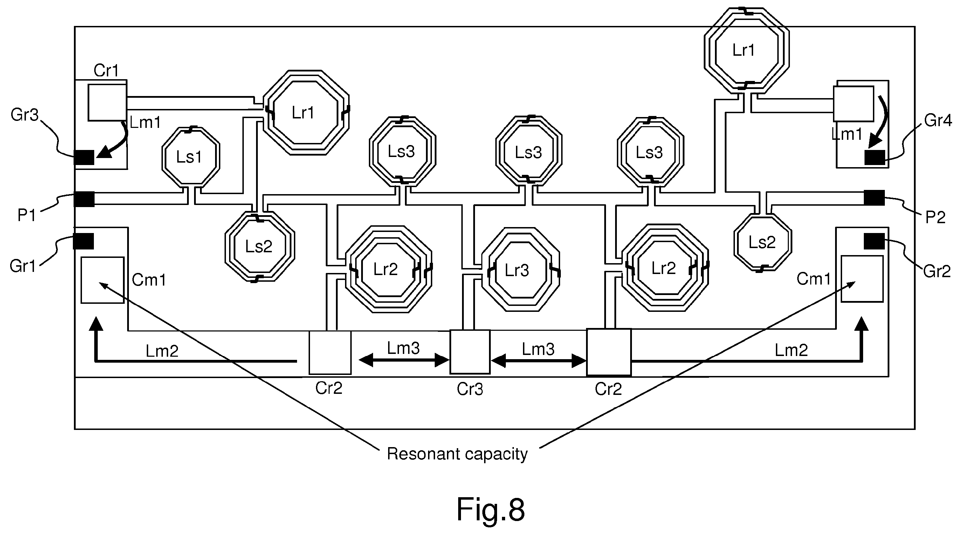

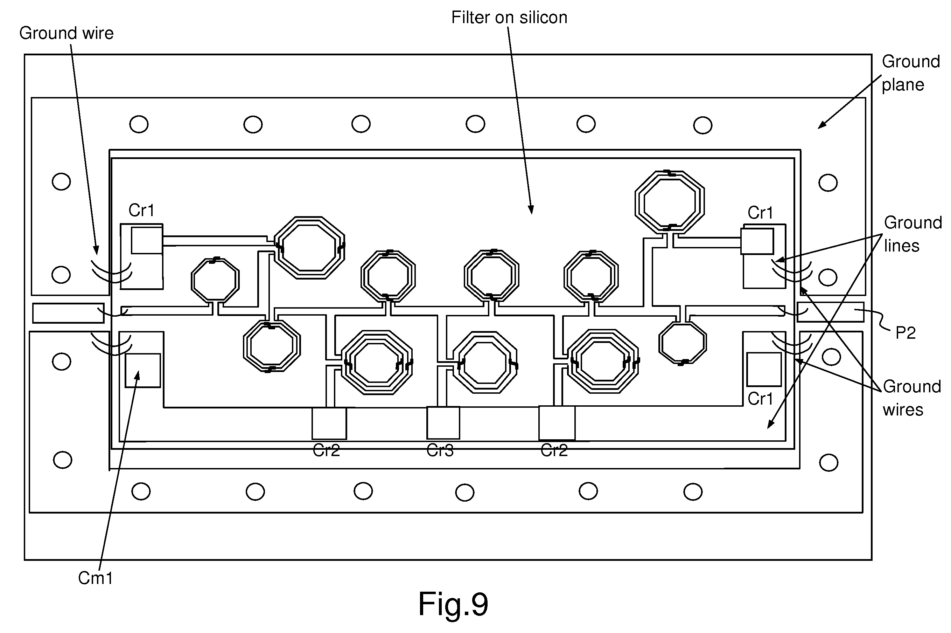

Les figures 8 et 9 montrent un design possible du circuit sur silicium Si-HR. Sur la figure 7 et en comparaison avec la figure 2, les capacités Cm1 et Cm2 sont ajoutées en extrémité des inductances parasites de masse de valeur Lm2 et en connexion avec les points de masse Gr1, Gr2. En série avec les inductances parasites de masse Lm1 sont connectées les capacités équivalentes Cr'1. Les inductances parasites de masse de valeur Lm3 sont représentées en connexion avec la capacité Cr3 du troisième résonateur et chacune des deux capacités Cr2 respectivement formant le deuxième résonateur. D'autres designs de ce circuit sont envisageables pour lesquels les inductances parasites de masse seront compensées par des éléments capacitifs On pourra noter sur la figure 7 que le filtre ne requiert plus que les connexions par des fils de masse des quatre points de masse Gr1, Gr2, Gr3 et Gr4 au plan de masse, soit deux à l'accès entrée et deux à l'accès sortie, au lieu d'une multitude requise par une solution usuelle représentée par la figure 5.
On a représenté sur les figures 10 et 11, un second mode de réalisation de la présente invention. La figure 10 représente un filtre passe bande d'ordre 7 comportant des éléments de couplage Ls1, Cs1 ; Ls2, Cs2 connectés en série entre un port d'entrée Term1 et un port de sortie Term2. Des éléments résonants parallèles de valeur Lp1/Cp1, Lp2/Cp2 sont connectés en parallèle entre les points de connexion des éléments de couplage des lignes de masse. Comme mentionné ci-dessus, les lignes de masse forment des éléments inductifs parasites représentés par les inductances Lm1, Lm2, Lm3. Conformément à la présente invention, une capacité Cm1 est connectée en série avec l'élément inductif Lm1 (et Cm2 respectivement à Lm2) pour ramener à la masse l'ensemble des éléments. La valeur des capacités Cm1 et Cm2 est calculée de manière à ce que chaque capacité résonne avec l'inductance série de masse à laquelle elle est connectée à une fréquence située au plus proche de la fréquence à rejeter. Lm3 de valeur faible ici, comparativement à Lm1 et Lm2, n'aura que peu d'incidence sur la réponse du filtre.
Les réponses en transmission et réflexion obtenues avec le filtre de la figure 10 sont représentées à la figure 11. La réponse en transmission montre clairement les zéros de transmission créés de part et d'autre de la bande passante du fait de l'ajout des 2 capacités Cm1 et Cm2. On démontre donc ici la compensation des effets néfastes des lignes de masse grâce à l'ajout de capacités. Cela permet non seulement de conserver des pertes d'insertion très faibles dans la bande passante du filtre mais aussi d'avoir une sélectivité en fréquence accrue.

## Revendications

1. Réseau de filtrage passe bande technologie silicium Si-HR défini par au moins une fréquence de coupure (fc) et comprenant:
une borne d'entrée (P1) pour recevoir le signal à filtrer et une borne de sortie (P2) pour fournir un signal filtré,
une première ligne de masse (M1) reliée par ses extrémités à un premier et un deuxième points de masse (Gr1), (Gr2), deux secondes lignes de masse (M2), reliées chacune respectivement à un troisième et un quatrième points de masse (Gr3, Gr4), les points de masse étant reliés à un plan de masse par l'intermédiaire de fils de masse, une pluralité d'éléments résonants L/C (Lr1/Cr1, Lr2/Cr2, Lr3/Cr3) connectés en parallèle et étant reliés par une extrémité à l'une des lignes de masse (M1, M2) et par l'autre extrémité, entre eux,
par l'intermédiaire d'inductances de couplage (Ls1, Ls2, Ls3) créant ainsi des zéros de transmission pour le signal à filtrer,
chaque ligne de masse (M1, M2) formant des éléments inductifs (Lm1, Lm2, Lm3),
**caractérisé en ce que**
le réseau comprend des éléments capacitifs (Cm1) en série entre au moins un des éléments résonants et au moins certains desdits éléments inductifs (Lm2), chacun de ces éléments inductifs et l'élément capacitif correspondant, à la fréquence de résonance en série correspondant, ramenant les éléments du filtre correspondants (Cm1, Lr2/Cr2, Lr3/Cr3) à un point de masse (Gr1), la valeur des éléments capacitifs étant choisie pour que la fréquence de résonance des éléments inductifs et capacitifs en série corresponde à une fréquence située en dehors de la bande passante.

## Patentansprüche

1. Bandpass-Filterungsnetz in der HR-SI-Siliziumtechnologie, das durch mindestens eine Grenzfrequenz (fc) definiert ist und Folgendes umfasst:
eine Eingangsklemme (P1) zum Empfang des zu filternden Signals und eine Ausgangsklemme (P2) zur Abgabe eines gefilterten Signals,
eine primäre Masseleitung (M1), die mit ihren äußeren Enden an einen ersten und einen zweiten Massepunkt (Gr1), (Gr2) angeschlossen ist, zwei sekundäre Masseleitungen (M2), von denen jede jeweils an einen dritten und einen vierten Massepunkt (Gr3, Gr4) angeschlossen ist, wobei die Massepunkte mittels Massekabel an eine Grundplatte angeschlossen sind, eine Vielzahl von Resonanzelementen L/C (Lr1/Cr1, Lr2/Cr2, Lr3/Cr3) parallel geschaltet sind und mit einem äußeren Ende mit einer der Masseleitungen (M1, M2) und mit dem anderen äußeren Ende miteinander durch Kopplungsspulen (Ls1, Ls2, Ls3) verbunden sind, und auf diese Weise Übertragungsnullstellen für das zu filternde Signal erzeugen, wobei jede Masseleitung (M1, M2) induktive Elemente (Lm1, Lm2, Lm3) bildet, **dadurch gekennzeichnet, dass** das Netz kapazitive Elemente (Cm1) in Serie zwischen mindestens einem der Resonanzelemente und mindestens bestimmten der besagten induktiven Elemente (Lm2) umfasst, wobei jedes dieser induktiven Elemente und das entsprechende kapazitive Element, mit der entsprechenden Serienresonanzfrequenz, die entsprechenden Elemente des Filters (Cm1, Lr2/Cr2, Lr3/Cr3) zu einem Massepunkt (Gr1) führt, wobei der Wert der kapazitiven Elemente so gewählt wird, dass die Resonanzfrequenz der induktiven und kapazitiven Elemente in Serie einer Frequenz entspricht, die sich außerhalb der Bandbreite befindet.

## Claims

1. HR-Si silicon technology band-pass filtering network defined by at least one cut-off frequency (fc) and comprising:
an input terminal (P1) to receive the signal to be filtered and an output terminal (P2) to provide a filtered signal,
a first ground line (M1) connected at its ends to first and second ground points (Gr1), (Gr2), two second ground lines (M2), each connected respectively to third and fourth ground points (Gr3, Gr4), the ground points being connected to a ground plane by means of ground wires, a plurality of L/C resonant elements (Lr1/Cr1, Lr2/Cr2,
Lr3/Cr3) connected in parallel and being connected at one end to one of the ground lines (M1, M2) and at the other end, to each other, by means of coupling inductors (Ls1, Ls2, Ls3) thus creating zero transmissions for the signal to be filtered, each ground line (M1, M2) forming inductive elements (Lm1, Lm2, Lm3), **characterised in that** the network comprises capacitive elements (Cm1) in series between at least one of the resonant elements and at least some of said inductive elements (Lm2), each of these inductive elements and the corresponding capacitive element, at the corresponding series resonant frequency, returning the corresponding elements of the filter (Cm1, Lr2/Cr2, Lr3/Cr3) to a ground point (Gr1), the value of the capacitive elements being chosen so that the resonant frequency of the inductive and capacitive elements in series corresponds to a frequency lying outside of the bandwidth.
